# EUROPEAN PATENT SPECIFICATION

(11) **EP 4 603 853 B1**
(45) Date of publication and mention of the grant of the patent: **28.10.2026**
(21) Application number: 25157218.6
(22) Date of filing: 11.02.2025
(51) Int. Cl.: G01R 31/3835, G01R 31/396

(54) **VOLTAGE DETECTION METHOD, DEVICE, VEHICLE, AND STORAGE MEDIUM**
SPANNUNGSDETEKTIONSVERFAHREN, VORRICHTUNG, FAHRZEUG UND SPEICHERMEDIUM
PROCÉDÉ DE DÉTECTION DE TENSION, DISPOSITIF, VÉHICULE ET SUPPORT D'INFORMATIONS

(30) Priority: 19.02.2024 CN 202410187788
(43) Date of publication of application: 20.08.2025
(73) Proprietor: BYD Company Limited, Shenzhen, Guangdong 518118 (CN)
(72) Inventor: ZHANG, Hongtu, Shenzhen 518118 (CN); SHU, Shiwei, Shenzhen 518118 (CN); FENG, Tianyu, Shenzhen 518118 (CN)
(74) Representative: Mathys & Squire

(56) References cited:
- CN-A- 116 736 166
- US-A1- 2021 365 478

## Description

### FIELD

The present disclosure relates to the technical field of batteries, and more specifically, to a voltage detection method, a device, a vehicle, and a storage medium.

### BACKGROUND

With rapid development of new energy industry, batteries, as core components of new energy, have gradually attracted the attention of consumers. Although energy storage batteries have many advantages such as large capacity, high energy density, and long service life, due to complex internal structures and production processes thereof, there may be problems such as low voltage or high voltage in a body cell (BC) of an energy storage battery during use, resulting in abnormal battery capacity and even a risk of short circuit inside the battery. Battery cell voltage outliers refer to significant differences or abnormalities in voltages of certain batteries or cells in a battery cell compared to other batteries. Therefore, how to effectively detect battery cell voltage outliers is an urgent problem to be solved. CN116736166A relates to a battery cell anomaly detection method and device of a battery pack and the battery pack. US2021/365478A1 relates to a system and a method for updating data models. **SUMMARY**

Aspects of the invention are as set out in the independent claims and optional features are set out in the dependent claims. Embodiments of the present disclosure provide a voltage detection method, a device, a vehicle, and a storage medium that can effectively detect a battery cell voltage and ensure efficient and safe operation of a battery system.

In a first aspect, an embodiment of the present disclosure provides a voltage detection method for execution by a processor. The method comprises:
a data set of a target object in at least one time interval is acquired, where the data set comprises voltages of battery cores included in at least one battery cell of the target object;
a voltage of a random battery cell in a random time interval is obtained based on voltages of battery cores included in the random battery cell included in a data set in the random time interval;
a voltage of the at least one battery cell in the random time interval is clustered based on a clustering algorithm to obtain multiple battery cell voltage clusters in the random time interval;
suspected voltage outlier clusters and voltage outlier clusters are determined from multiple battery cell voltage clusters in the at least one time interval; and
whether the target object has battery cell voltage outliers is determined based on a number of the suspected voltage outlier clusters and a number of the voltage outlier clusters.

In a second aspect, an embodiment of the present disclosure provides a voltage detection apparatus. The voltage detection apparatus comprises: an acquisition unit, a processing unit, and a determination unit.

The acquisition unit is configured to acquire a data set of a target object in at least one time interval, where the data set comprises voltages of battery cores included in at least one battery cell of the target object.

The processing unit is configured to obtain a voltage of a random battery cell in a random time interval based on voltages of battery cores included in the random battery cell included in a data set in the random time interval.

The processing unit is further configured to cluster a voltage of the at least one battery cell in the random time interval based on a clustering algorithm to obtain multiple battery cell voltage clusters in the random time interval.

The determination unit is configured to determine suspected voltage outlier clusters and voltage outlier clusters from multiple battery cell voltage clusters in the at least one time interval.

The determination unit is further configured to determine whether the target object has battery cell voltage outliers based on a number of the suspected voltage outlier clusters and a number of the voltage outlier clusters.

In one embodiment, a method for determining the voltage outlier clusters by the determination unit comprises:
a first voltage mean of voltages within a currently traversed suspected voltage outlier cluster, and second voltage means of suspected voltage outlier clusters, other than the currently traversed suspected voltage outlier cluster, in the suspected voltage outlier clusters in the at least one time interval are acquired; and
the voltage outlier clusters are determined based on the first voltage mean and each of the second voltage means until the traversal ends.

In one embodiment, the step that the determination unit determines the voltage outlier clusters based on the first voltage mean and each of the second voltage means until the traversal ends comprises:
the currently traversed suspected voltage outlier cluster is determined as the voltage outlier cluster if an absolute value of a difference between each of the second voltage means and the first voltage mean is greater than a first preset voltage threshold, until the traversal ends.

In one embodiment, the step that the determination unit determines whether the target object has the battery cell voltage outliers based on the number of the suspected voltage outlier clusters and the number of the voltage outlier clusters comprises:
it is determined that the target object has the battery cell voltage outliers if a ratio of the number of the voltage outlier clusters to the number of the suspected voltage outlier clusters is greater than a first preset ratio threshold, or a difference between the number of the voltage outlier clusters and a number of suspected voltage outlier clusters, other than the voltage outlier clusters, in the suspected voltage outlier clusters is greater than a preset number threshold.

In one embodiment, the acquisition unit is further configured to
acquire object data of the target object, where the object data of the target object comprises voltages of battery cores included in at least one battery cell of the target object in a historical time period; and
partition the object data of the target object to obtain a data set of the target object in at least one time interval.

In one embodiment, the object data further comprises: a state of charge of each of the battery cores included in the at least one battery cell in the target object in the historical time period.

The step that the processing unit partitions the object data of the target object to obtain the data set in the at least one time interval of the target object comprises: voltages of the battery cores included in the at least one battery cell at a random time point are acquired from the object data;
a target voltage at the random time point is acquired from at least one voltage at the random time point, where the target voltage is higher than other voltages in the at least one voltage;
a target state of charge of a battery core corresponding to the target voltage at the random time point is acquired;
target object data is determined based on the target voltage and the target state of charge; and
the target object data being continuous in time in the object data is determined as a data set in a time interval to obtain the data set in the at least one time interval.

In one embodiment, the step that the determination unit determines the target object data based on the target voltage and the target state of charge comprises:
object data at the random time point in the object data is determined as the target object data if the target voltage is greater than a second preset voltage threshold and the target state of charge is greater than a second preset ratio threshold.

In one embodiment, the object data further comprises: a current of a random battery core included in the at least one battery cell in the target object in the historical time period.

The step that the processing unit partitions the object data of the target object to obtain the data set in the at least one time interval of the target object comprises: a current of the random battery core at a random time point, and currents of the random battery core at k time points adjacent to the random time point, are acquired from the object data, and k is a positive integer;
the target object data is determined based on the current at the random time point and the currents at the k adjacent time points; and
the target object data being continuous in time in the object data is determined as a data set in a time interval to obtain the data set in the at least one time interval.

In one embodiment, the step that the determination unit determines the target object data based on the current at the random time point and the currents at the k adjacent time points comprises:
the object data at the random time point in the object data is determined as the target object data if the current at the random time point is less than a first preset current threshold, and a difference between a maximum current and a minimum current of the currents at the k adjacent time points and the current at the random time point is less than a second preset current threshold.

In one embodiment, the step that the processing unit clusters the voltage of the at least one battery cell in the random time interval based on the clustering algorithm to obtain the multiple battery cell voltage clusters in the random time interval comprises:
the voltage of the at least one battery cell in the random time interval is clustered based on the clustering algorithm to obtain multiple candidate battery cell voltage clusters;
the multiple candidate battery cell voltage clusters are clustered based on the clustering algorithm to obtain multiple clustered candidate battery cell voltage clusters if a number of the multiple candidate battery cell voltage clusters is greater than a preset value;
the multiple clustered candidate battery cell voltage clusters are taken as multiple candidate battery cell voltage clusters if a number of the multiple clustered candidate battery cell voltage clusters is greater than the preset value, and performance of clustering the multiple candidate battery cell voltage clusters based on the clustering algorithm is triggered to obtain multiple clustered candidate battery cell voltage clusters, until the number of the multiple clustered candidate battery cell voltage clusters obtained is equal to the preset value; and
the multiple clustered candidate battery cell voltage clusters with the number being equal to the preset value are determined as the multiple battery cell voltage clusters in the random time interval.

In a third aspect, an embodiment of the present disclosure provides a computer device. The computer device comprises a memory, a communication interface, and a processor, where the memory, the communication interface, and the processor are interconnected. The memory stores a computer program, and the processor calls the computer program stored in the memory to implement the method of the first aspect.

In a fourth aspect, an embodiment of the present disclosure provides a vehicle. The vehicle comprises a vehicle body and a processor, and the processor is configured to execute the method of the first aspect.

In a fifth aspect, an embodiment of the present disclosure provides a computer-readable storage medium. The computer-readable storage medium stores a computer program, and the computer program, when executed by a processor, implements the method of the first aspect.

In a sixth aspect, an embodiment of the present disclosure provides a computer program product. The computer program product comprises a computer program, and the computer program is stored in a computer storage medium. A processor of a computer device reads the computer program from the computer storage medium, and the processor executes the computer program to cause the computer device to execute the above voltage detection method.

In the embodiments of the present disclosure, a data set of a target object in at least one time interval is acquired, where the data set comprises voltages of battery cores comprised in at least one battery cell of the target object; a voltage of a random battery cell in a random time interval is obtained based on voltages of battery cores included in the random battery cell included in a data set in the random time interval; a voltage of the at least one battery cell in the random time interval is clustered based on a clustering algorithm to obtain multiple battery cell voltage clusters in the random time interval; suspected voltage outlier clusters and voltage outlier clusters are determined from multiple battery cell voltage clusters in the at least one time interval; and whether the target object has battery cell voltage outliers is determined based on a number of the suspected voltage outlier clusters and a number of the voltage outlier clusters. After the suspected voltage outlier clusters in the battery cell are detected, the voltage outlier clusters are determined, so that the battery cell voltage can be effectively detected and efficient and safe operation of a battery system can be ensured.

### BRIEF DESCRIPTION OF THE DRAWINGS

To describe the technical solutions in the embodiments of the present disclosure or the background more clearly, the following briefly describes accompanying drawings required for describing the embodiments of the present disclosure or the background.
FIG. 1 is a schematic architecture diagram of a voltage detection system provided in an embodiment of the present disclosure;
FIG. 2 is a schematic flow diagram of a voltage detection method provided in an embodiment of the present disclosure;
FIG. 3 is a schematic flow diagram of a clustering algorithm provided in an embodiment of the present disclosure;
FIG. 4 is a schematic flow diagram of another voltage detection method provided in an embodiment of the present disclosure;
FIG. 5 is a schematic structural diagram of a voltage detection apparatus provided in an embodiment of the present disclosure; and
FIG. 6 is a schematic structural diagram of a computer device provided in an embodiment of the present disclosure.

### DETAILED DESCRIPTION

Exemplary embodiments are described in detail herein, and examples of the exemplary embodiments are shown in the accompanying drawings. When the following description involves the accompanying drawings, unless otherwise indicated, the same numerals in different accompanying drawings represent the same or similar elements. Implementations described in the following exemplary embodiments do not represent all implementations consistent with the present disclosure. On the contrary, the implementations are merely examples of apparatuses and methods that are consistent with some aspects of the present disclosure and as described in detail in claims.

It should be noted that, terms "include", "comprise", or any other variant thereof are intended to cover a non-exclusive inclusion, so that a process, method, article, or apparatus that includes a series of elements not only includes such elements, but also includes other elements not expressly listed, or further includes elements inherent to such a process, method, article, or apparatus. Without further limitations, an element defined by the statement "including one..." does not exclude the existence of other identical elements in a process, method, article, or apparatus that includes the element. In addition, a component, feature, or element with the same name in different embodiments of the present disclosure may have the same meaning or different meanings, and the specific meanings thereof need to be determined by their interpretation in the specific embodiment or further combined with the context of the specific embodiment.

It should be understood that although terms such as "first", "second", and "third", may be used herein to describe various information, the information should not be limited by these terms. These terms are merely used for distinguishing between information of the same type. For example, without departing from the scope of the present disclosure, first information may also be referred to as second information, and similarly, second information may also be referred to as first information. Depending on the context, for example, the word "if" used herein may be interpreted as "while", or "when", or "in response to determining". Furthermore, as used herein, singular forms "a", "one", and "the" are meant to include plural forms, unless contrarily indicated in the context. It should be further understood that the terms "comprise" and "include" indicate the existence of the described features, steps, operations, elements, components, items, categories, and/or groups, but do not exclude the existence, appearance, or addition of one or more other features, steps, operations, elements, components, items, categories, and/or groups. Terms "or", "and/or", "including at least one of the following" and the like used in the present disclosure may be interpreted as inclusive, or implying any one or any combination thereof. For example, "including at least one of the following: A, B, and C" means "any one of the following: A; B; C; A and B; A and C; B and C; and A and B and C". For another example, "A, B or C" or "A, B and/or C" means "any of the following: A; B; C; A and B; A and C; B and C; and A and B and C". Exceptions to this definition only occur when a combination of components, functions, steps, or operations are inherently mutually exclusive in certain ways.

It is to be understood that, although the steps are displayed sequentially according to the instructions of the arrows in the flowcharts of the embodiments of the present disclosure, these steps are not necessarily performed sequentially according to the sequence instructed by the arrows. Unless explicitly specified in this specification, execution of the steps is not strictly limited in the sequence, and the steps may be performed in other sequences. In addition, at least some steps in the flowcharts may include multiple substeps or multiple stages. These substeps or stages are not necessarily performed at the same moment, but may be performed at different moments. The substeps or stages are not necessarily performed in sequence, but may be performed in turn or alternately with other steps or at least some of substeps or stages of the other steps.

Depending on the context, for example, words "if" or "as if" used herein may be explained as "while ..." or "when ..." or "in response to determining" or "in response to detecting". Similarly, depending on the context, phrases "if determining" or "if detecting (a stated condition or event)" may be interpreted as "when determining" or "in response to determining" or "when detecting (the stated condition or event)" or "in response to detecting (the stated condition or event)."

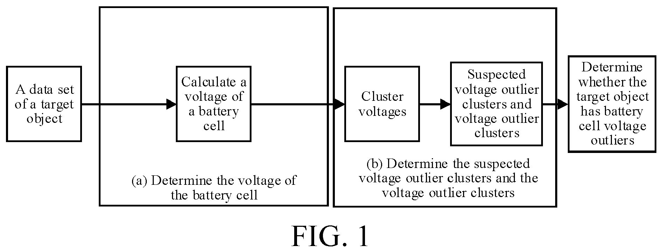

Referring to FIG. 1, FIG. 1 is a schematic architecture diagram of a voltage detection system provided in an embodiment of the present disclosure. A target object may refer to a vehicle carrying a battery or a photovoltaic system equipped with an energy storage battery.

Exemplarily, a data set of a target object in at least one time interval is acquired, where the data set includes voltages of battery cores included in at least one battery cell of the target object; a voltage of a random battery cell in a random time interval is obtained based on voltages of battery cores included in the random battery cell included in a data set in the random time interval; a voltage of the at least one battery cell in the random time interval is clustered based on a clustering algorithm to obtain multiple battery cell voltage clusters in the random time interval; suspected voltage outlier clusters and voltage outlier clusters are determined from multiple battery cell voltage clusters in the at least one time interval; and whether the target object has battery cell voltage outliers is determined based on a number of the suspected voltage outlier clusters and a number of the voltage outlier clusters.

Optionally, after collecting original data of the target object, the target object uploads the original data to a cloud server, and a processor can acquire the original data of the target object from the cloud, sequence the original data by time, and obtain the object data of the target object.

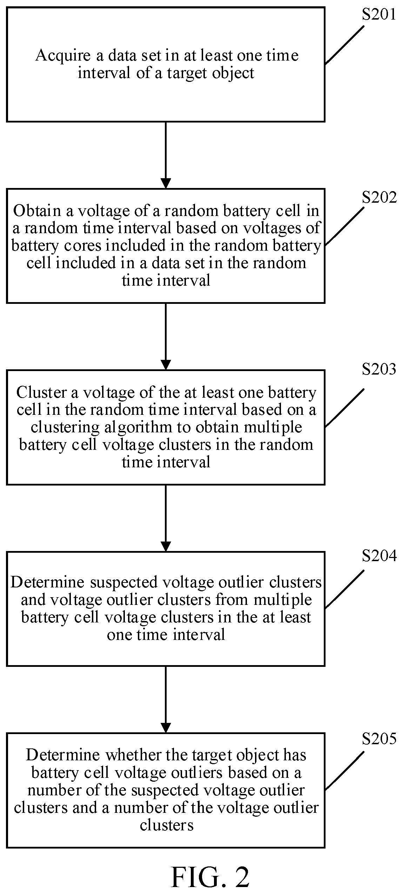

Referring to FIG. 2, FIG. 2 is a schematic flow diagram of a voltage detection method provided in an embodiment of the present disclosure. The voltage detection method shown in FIG. 2 comprises but is not limited to steps S201 to S205 as follows:
S201, a data set of a target object in at least one time interval is acquired.

In this embodiment, the target object may refer to a vehicle carrying a battery or a photovoltaic system equipped with an energy storage battery. For example, the target object is a target vehicle. After the vehicle collects vehicle data, the vehicle data is uploaded to a cloud server or a local server, and a central processing unit (CPU) acquires the data set in at least one time interval of the target object.

In one implementation, the method further comprises:
object data of the target object is acquired, where the object data of the target object comprises voltages of battery cores included in at least one battery cell of the target object in a historical time period; and
the object data of the target object is partitioned to obtain the data set in the at least one time interval of the target object.

In this embodiment, the CPU partitions the vehicle data to obtain the data set in at least one time interval of the target vehicle.

In one implementation, the object data further comprises: a state of charge of each of the battery cores included in the at least one battery cell in the target object in the historical time period.

The step that the object data of the target object is partitioned to obtain the data set in the at least one time interval of the target object comprises: voltages of the battery cores included in the at least one battery cell at a random time point are acquired from the object data;
a target voltage at the random time point is acquired from at least one voltage at the random time point, where the target voltage is higher than other voltages in the at least one voltage;
a target state of charge of a battery core corresponding to the target voltage at the random time point is acquired;
target object data is determined based on the target voltage and the target state of charge; and
the target object data being continuous in time in the object data is determined as a data set in a time interval to obtain the data set in the at least one time interval.

In this embodiment, the voltage of each of the battery cores included in the at least one battery cell at a random time point is acquired from the vehicle data, and the target voltage at the random time point is acquired from the at least one voltage at the random time point. The target voltage is higher than other voltages in the at least one voltage, i.e., the target voltage is the highest voltage. The state of charge (SOC) of the battery core corresponding to the highest voltage is acquired, where the state of charge refers to the percentage of the amount of electricity stored in a battery relative to the total capacity. Target vehicle data is determined based on the highest voltage and the state of charge at the highest voltage. The target vehicle data being continuous in time in the vehicle data is determined as a data set in a time interval to obtain the data set in the at least one time interval.

In one implementation, the step that the target object data is determined based on the target voltage and the target state of charge comprises:
object data at the random time point in the object data is determined as the target object data if the target voltage is greater than a second preset voltage threshold and the target state of charge is greater than a second preset ratio threshold.

In this embodiment, the vehicle data at the random time point in the vehicle data is determined as the target vehicle data if the highest voltage is greater than the second preset voltage threshold, for example, the second preset voltage threshold is 3 V, and if the highest voltage is greater than 3 V, and the state of charge of the battery core corresponding to the highest voltage is greater than the second preset ratio threshold, for example, the second preset ratio threshold is 60%, and if the state of charge of the battery core corresponding to the highest voltage is greater than 60%.

In one implementation, the object data further comprises: a current of a random battery core included in the at least one battery cell in the target object in the historical time period.

The step that the object data of the target object is partitioned to obtain the data set in the at least one time interval of the target object comprises: a current of the random battery core at a random time point, and currents of the random battery core at k time points adjacent to the random time point, are acquired from the object data, and k is a positive integer;
the target object data is determined based on the current at the random time point and the currents at the k adjacent time points; and
the target object data being continuous in time in the object data is determined as a data set in a time interval to obtain the data set in the at least one time interval.

In this embodiment, the current of the random battery core at the random time point, and the currents at the k time points adjacent to the random time point of the random battery core, are acquired from the vehicle data, and k is a positive integer, where the k time points may be k time points before the random time point, the k time points may also be k time points after the random time point, and the k time points may also be a total of k time points before and after the random time point. The target object data is determined based on the current at the random time point and the currents at the k adjacent time points; and the target object data being continuous in time in the object data is determined as a data set in a time interval to obtain the data set in the at least one time interval.

In one implementation, the step that the target object data is determined based on the current at the random time point and the currents at the k adjacent time points comprises:
the object data at the random time point in the object data is determined as the target object data if the current at the random time point is less than a first preset current threshold, and a difference between a maximum current and a minimum current of the currents at the k adjacent time points and the current at the random time point is less than a second preset current threshold.

In this embodiment, vehicle data at a random time point in the vehicle data is determined as the target vehicle data if the current at the random time point is less than the first preset current threshold, and the difference between the maximum current and the minimum current of the currents at the k adjacent time points and the current at the random time point is less than the second preset current threshold. For example, k is 4, the first preset current threshold is 0.2 A, the second preset current threshold is 1 A, and then the currents at a random time point and the 4 adjacent time points are acquired. The vehicle data at the random time point in the vehicle data is determined as the target vehicle data if the current at the random time point is less than 0.2 A, and the difference between the maximum current and the minimum current of the currents at the random time point and the 4 adjacent time points is less than 1 A.

Optionally, original vehicle data of the target vehicle may be acquired from a cloud big data platform, and the vehicle data may be preprocessed to obtain the vehicle data. For example, the preprocessing may involve deleting illegal data generated due to software and hardware sampling failures, cloud communication failures, and parsing errors at the target vehicle end; and data is resequenced based on time, only one frame of data is retained for data with the same time, and the original vehicle data is preprocessed to obtain the vehicle data.

S202, a voltage of a random battery cell in a random time interval is obtained based on voltages of battery cores included in the random battery cell included in a data set in the random time interval.

In this embodiment, the voltage of the battery cell corresponding to each of the battery cores is determined by the voltage of each of the battery cores. For example, the voltage of the battery cell is obtained by accumulating the voltages of the battery cores, that is, 9 V if the battery cell comprises a first battery core, a second battery core, and a third battery core, and the voltage of the first battery core is 2 V, the voltage of the second battery core is 3 V, and the voltage of the third battery core is 3 V.

S203, a voltage of the at least one battery cell in the random time interval is clustered based on a clustering algorithm to obtain multiple battery cell voltage clusters in the random time interval.

In this embodiment, the voltage of the at least one battery cell in the random time interval is clustered by the clustering algorithm to obtain the multiple battery cell voltage clusters in the random time interval.

In one implementation, the step that the voltage of the at least one battery cell in the random time interval based on the clustering algorithm to obtain the multiple battery cell voltage clusters in the random time interval comprises:
the voltage of the at least one battery cell in the random time interval is clustered based on the clustering algorithm to obtain multiple candidate battery cell voltage clusters;
the multiple candidate battery cell voltage clusters are clustered based on the clustering algorithm to obtain multiple clustered candidate battery cell voltage clusters if a number of the multiple candidate battery cell voltage clusters is greater than a preset value;
the multiple clustered candidate battery cell voltage clusters are taken as multiple candidate battery cell voltage clusters if a number of the multiple clustered candidate battery cell voltage clusters is greater than the preset value, and performance of clustering the multiple candidate battery cell voltage clusters based on the clustering algorithm is triggered to obtain multiple clustered candidate battery cell voltage clusters, until the number of the multiple clustered candidate battery cell voltage clusters obtained is equal to the preset value; and
the multiple clustered candidate battery cell voltage clusters with the number being equal to the preset value are determined as the multiple battery cell voltage clusters in the random time interval.

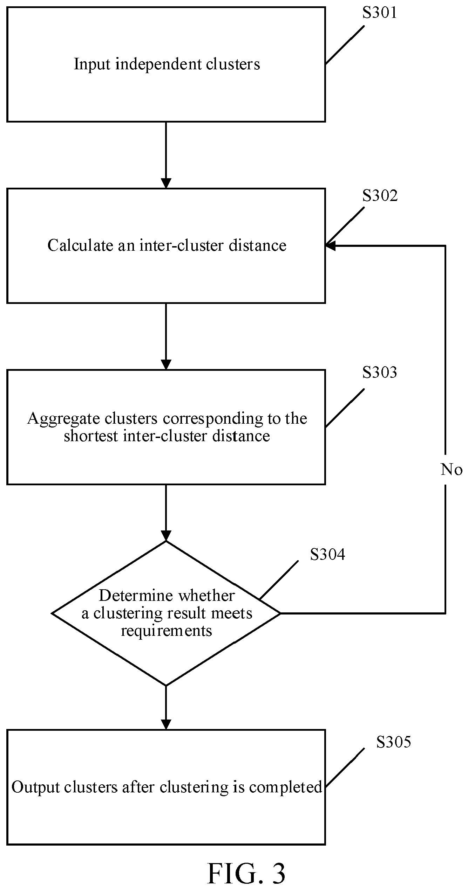

In this embodiment, refer to FIG. 3, FIG. 3 is a schematic flow diagram of a clustering algorithm provided in an embodiment of the present disclosure.

S301, independent clusters are inputted.

Voltage data of a single battery cell within a vehicle data segment is inputted as an independent cluster.

S302, an inter-cluster distance is calculated.

The inter-cluster distance is calculated based on features of the voltage data of the single battery cell and task requirements. The inter-cluster distance may be calculated by optional clustering algorithms including Single Linkage, Complete Linkage, Average Linkage, or Ward Linkage.

S303, clusters corresponding to the shortest inter-cluster distance are aggregated.

Voltage data of all battery cells in the clusters with the shortest inter-cluster distance is aggregated to form new clusters, to obtain multiple candidate battery cell voltage clusters.

S304, whether a clustering result meets requirements is determined.

Whether the current clustering result meets the requirements is analyzed. That is, a number of clusters obtained from the final clustering is N, a value of N is not fixed and is generally 2 or 3, for example, the requirements are met if N is 2 and the number of clusters obtained from the final clustering is 2, and the clustering algorithm ends. The requirements are not met if the number of clusters obtained from the final clustering is greater than 2, and step S302 is performed to calculate the inter-cluster distance. The multiple candidate battery cell voltage clusters obtained after clustering are taken as multiple candidate battery cell voltage clusters to continue calculating the inter-cluster distance to perform clustering if the number of the multiple candidate battery cell voltage clusters after clustering is greater than the preset number 2, until the number of the multiple candidate battery cell voltage clusters after clustering is equal to the preset number 2.

S305, clusters after clustering is completed are outputted.

After clustering is completed, preset N battery cell voltage clusters in a random time interval are obtained.

S204, suspected voltage outlier clusters and voltage outlier clusters are determined from multiple battery cell voltage clusters in the at least one time interval.

In one implementation, a method for determining the voltage outlier clusters comprises:
a first voltage mean of voltages within a currently traversed suspected voltage outlier cluster, and second voltage means of suspected voltage outlier clusters, other than the currently traversed suspected voltage outlier cluster, in the suspected voltage outlier clusters in the at least one time interval are acquired; and
the voltage outlier clusters are determined based on the first voltage mean and each of the second voltage means until the traversal ends.

In this embodiment, after clustering is completed, preset N battery cell voltage clusters are obtained. Among the N battery cell voltage clusters, a cluster with the fewest number of battery cell voltage data is determined as a suspected outlier cluster. Suspected voltage outlier clusters in at least one time interval are traversed, and a first voltage mean of voltages within a currently traversed suspected voltage outlier cluster, and second voltage means of suspected voltage outlier clusters, other than the currently traversed suspected voltage outlier cluster, in the suspected voltage outlier clusters in the at least one time interval are acquired, and the voltage outlier clusters are determined based on the first voltage mean and each of the second voltage means until the traversal ends.

In one implementation, the step that the voltage outlier clusters are determined based on the first voltage mean and each of the second voltage means until the traversal ends comprises:
the currently traversed suspected voltage outlier cluster is determined as the voltage outlier cluster if an absolute value of a difference between each of the second voltage means and the first voltage mean is greater than a first preset voltage threshold, until the traversal ends.

In this embodiment, for example, the absolute values of the differences between the second voltage means and the first voltage mean are 1 V, 1.2 V, and 1.3 V respectively if the first preset voltage threshold is 0.5 V, the first voltage mean of the currently traversed suspected voltage outlier cluster is 4 V, and the second voltage means are 5 V, 5.2 V, and 5.3 V respectively. The absolute value of the difference between each of the second voltage means and the first voltage mean is greater than the first preset voltage threshold, then the currently traversed suspected voltage outlier cluster is determined as the voltage outlier cluster, until the traversal ends. In a case where BC voltage data in each of time intervals is acquired, information of the suspected voltage outlier clusters can be obtained by simply inputting the number N of clusters when clustering of external parameters is completed into a clustering algorithm. It is unnecessary to design detection thresholds based on historical data, battery production processes, battery models, and other information of a detected battery. Therefore, the method has high self-adaptability.

S205, whether the target object has battery cell voltage outliers is determined based on a number of the suspected voltage outlier clusters and a number of the voltage outlier clusters.

In one implementation, the step that whether the target object has the battery cell voltage outliers is determined based on the number of the suspected voltage outlier clusters and the number of the voltage outlier clusters comprises:
it is determined that the target object has the battery cell voltage outliers if a ratio of the number of the voltage outlier clusters to the number of the suspected voltage outlier clusters is greater than a first preset ratio threshold, or a difference between the number of the voltage outlier clusters and a number of suspected voltage outlier clusters, other than the voltage outlier clusters, in the suspected voltage outlier clusters is greater than a preset number threshold.

In this embodiment, the target object may refer to a vehicle carrying a battery or a photovoltaic system equipped with an energy storage battery. For example, the target object is a target vehicle. The number of determined voltage outlier clusters and suspected voltage outlier clusters are acquired. For example, the first preset ratio threshold is 50%, the number of the voltage outlier clusters is 6, the number of the suspected voltage outlier clusters is 10, the ratio of the voltage outlier clusters to the suspected voltage outlier clusters is 60%, and 60% is greater than 50%, then it is determined that the target vehicle has the battery cell voltage outliers; or, the preset number threshold is 10, the number of the voltage outlier clusters is 20, the number of the suspected voltage outlier clusters is 5, the difference between the number of the voltage outlier clusters and the number of the suspected voltage outlier clusters is 15, and the difference 15 is greater than the preset number threshold 10, then it is determined that the target vehicle has battery cell voltage outliers. By adjusting the first preset ratio threshold or the preset number threshold, a width of a detection window can be adjusted, and detection criteria can be specifically adjusted for objects of major concerns.

In the embodiments of the present disclosure, a data set of a target object in at least one time interval is acquired, where the data set comprises voltages of battery cores included in at least one battery cell of the target object; a voltage of a random battery cell in a random time interval is obtained based on voltages of battery cores included in the random battery cell included in a data set in the random time interval; the voltage of the at least one battery cell in the random time interval is clustered based on a clustering algorithm to obtain multiple battery cell voltage clusters in the random time interval; suspected voltage outlier clusters and voltage outlier clusters are determined from multiple battery cell voltage clusters in the at least one time interval; and whether the target object has battery cell voltage outliers is determined based on a number of the suspected voltage outlier clusters and a number of the voltage outlier clusters. After the suspected voltage outlier clusters in the battery cell are detected, the voltage outlier clusters are determined, so that the battery cell voltage can be effectively detected and efficient and safe operation of a battery system can be ensured.

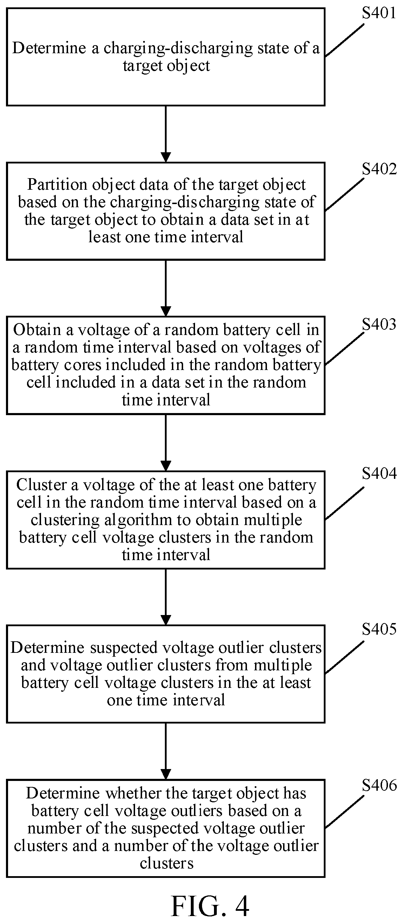

Referring to FIG. 4, FIG. 4 is a schematic flow diagram of another voltage detection method provided in an embodiment of the present disclosure. The voltage detection method shown in FIG. 4 comprises but is not limited to steps S401 to S406 as follows:
S401, a charging-discharging state of a target object is determined.

In this embodiment, the target object may refer to a vehicle carrying a battery or a photovoltaic system equipped with an energy storage battery. For example, the target object is a target vehicle. First, the charging-discharging state of the vehicle is determined based on vehicle data obtained from a cloud.

Optionally, the charging-discharging state of the vehicle is determined by current data. For example, a positive current typically indicates charging, while a negative current indicates discharging. A zero current typically indicates that a battery is stationary, meaning that the battery is neither charging nor discharging.

Optionally, the charging-discharging state of the vehicle is determined by voltage data. For example, a high voltage may indicate charging, while a low voltage may indicate discharging.

Optionally, the charging-discharging state of the vehicle is determined by a state of charge. The state of charge refers to a ratio of an amount of electricity currently stored in a battery to a total capacity of the battery, typically expressed as a percentage. The battery is charged if a value of the state of charge increases, and the battery is discharged if the value of the state of charge decreases.

Optionally, the charging-discharging state of the vehicle is determined by an operating condition of the vehicle. For example, it is likely that the battery is in a discharging state if the vehicle is in motion and a battery current is positive. The battery may be charged if the vehicle stops and the current is positive.

Optionally, the charging-discharging state of the vehicle may be comprehensively determined based on the current, voltage, state of charge, and operating condition of the vehicle.

S402, object data of the target object is partitioned based on the charging-discharging state of the target object to obtain a data set in at least one time interval.

In this embodiment, optionally, vehicle data of the target vehicle is partitioned based on a partitioning method during charging if the target vehicle is in a charging state, to obtain the data set in the at least one time interval.

In one implementation, the object data further comprises: a state of charge of each of battery cores included in at least one battery cell in the target object in a historical time period.

The step that the object data of the target object is partitioned to obtain the data set in the at least one time interval of the target object comprises: voltages of the battery cores included in the at least one battery cell at a random time point are acquired from the object data;
a target voltage at the random time point is acquired from at least one voltage at the random time point, where the target voltage is higher than other voltages in the at least one voltage;
a target state of charge of a battery core corresponding to the target voltage at the random time point is acquired;
target object data is determined based on the target voltage and the target state of charge; and
the target object data being continuous in time in the object data is determined as a data set in a time interval to obtain the data set in the at least one time interval.

In this embodiment, the voltages of the battery cores included in the at least one battery cell at the random time point are acquired from vehicle sequence data if the target vehicle is in a charging state, and the target voltage at the random time point is acquired from the at least one voltage at the random time point. The target voltage is higher than other voltages in the at least one voltage, i.e., the target voltage is the highest voltage. The SOC of the battery core corresponding to the highest voltage is acquired. Target vehicle data is determined based on the highest voltage and the SOC at the highest voltage. The target vehicle data being continuous in time in the vehicle data is determined as a data set in a time interval to obtain the data set in the at least one time interval.

In one implementation, the step that the target object data is determined based on the target voltage and the target state of charge comprises:
object data at the random time point in the object data is determined as the target object data if the target voltage is greater than a second preset voltage threshold and the target state of charge is greater than a second preset ratio threshold.

In this embodiment, the vehicle data at the random time point in the vehicle data is determined as the target vehicle data if the highest voltage is greater than the second preset voltage threshold, for example, the second preset voltage threshold is 3 V, if the highest voltage is greater than 3 V, and the SOC of the battery core corresponding to the highest voltage is greater than the second preset ratio threshold, for example, the second preset ratio threshold is 60%, if the state of charge of the battery core corresponding to the highest voltage is greater than 60%. The target vehicle data being continuous in time in the vehicle data is determined as a data set in a time interval to obtain the data set in the at least one time interval, and the data set is a high SOC charging stage. Intercepting the high SOC charging stage as the data set can avoid an adverse effect of voltage characteristics of lithium iron phosphate batteries on voltages of individual cells (ICs). The voltage characteristics of the lithium iron phosphate batteries refer to the existence of a plateau during a charging process, and in the plateau, a voltage difference between ICs with large SOC differences is not significant and cannot be clustered for analysis. In contrast, in the high SOC charging stage, the voltage of the IC is more affected by the SOC, and information about changes in the voltage of the IC caused by problems with the battery cores is easier to acquire. Due to an upward trend of resistance in the high SOC charging stage, even small differences in resistance can have a significant impact on voltage. Interception of a high SOC charging point is performed to avoid the adverse effect of the voltage characteristics of the lithium iron phosphate batteries on the voltages of the ICs.

Optionally, the vehicle data of the target vehicle is partitioned based on a partitioning method during discharging if the target vehicle is in a discharging state, to obtain the data set in the at least one time interval.

In one implementation, the object data further comprises: a current of a random battery core included in the at least one battery cell in the target object in the historical time period.

The step that the object data of the target object is partitioned to obtain the data set in the at least one time interval of the target object comprises: a current of the random battery core at a random time point, and currents of the random battery core at k time points adjacent to the random time point, are acquired from the object data, and k is a positive integer;
the target object data is determined based on the current at the random time point and the currents at the k adjacent time points; and
the target object data being continuous in time in the object data is determined as a data set in a time interval to obtain the data set in the at least one time interval.

In this embodiment, the current of the random battery core at the random time point, and the currents of the random battery core at the k time points adjacent to the random time point, are acquired from a vehicle data sequence if the target vehicle is in a discharging state, and k is a positive integer, where the k time points may be k time points before the random time point, the k time points may also be k time points after the random time point, and the k time points may also be a total of k time points before and after the random time point. The target vehicle data is determined based on the current at the random time point and the currents at the k adjacent time points; and the target vehicle data being continuous in time in the vehicle data is determined as a data set in a time interval to obtain the data set in the at least one time interval.

In one implementation, the step that the target object data is determined based on the current at the random time point and the currents at the k adjacent time points comprises:
the object data at the random time point in the object data is determined as the target object data if the current at the random time point is less than a first preset current threshold, and a difference between a maximum current and a minimum current of the currents at the k adjacent time points and the current at the random time point is less than a second preset current threshold.

In this embodiment, vehicle data at a random time point in the vehicle data is determined as the target vehicle data if the current at the random time point is less than the first preset current threshold, and the difference between the maximum current and the minimum current of the currents at the k adjacent time points and the current at the random time point is less than the second preset current threshold. For example, k is 4, the first preset current threshold is 0.2 A, the second preset current threshold is 1 A, and then the currents at a random time point and the 4 adjacent time points are acquired. The vehicle data at the random time point in the vehicle data is determined as the target vehicle data if the current at the random time point is less than 0.2 A, and the difference between the maximum current and the minimum current of the currents at the random time point and the 4 adjacent time points is less than 1 A.

S403, a voltage of a random battery cell in a random time interval is obtained based on voltages of battery cores included in the random battery cell included in a data set in the random time interval.

Refer to step S202 for the specific step of this embodiment, and the description of this step is omitted herein.

S404, a voltage of the at least one battery cell in the random time interval is clustered based on a clustering algorithm to obtain multiple battery cell voltage clusters in the random time interval.

Refer to step S203 for the specific step of this embodiment, and the description of this step is omitted herein.

S405, suspected voltage outlier clusters and voltage outlier clusters are determined from multiple battery cell voltage clusters in the at least one time interval.

Refer to step S204 for the specific step of this embodiment, and the description of this step is omitted herein.

S406, whether the target object has battery cell voltage outliers is determined based on a number of the suspected voltage outlier clusters and a number of the voltage outlier clusters.

Refer to step S205 for the specific step of this embodiment, and the description of this step is omitted herein.

In the embodiments of the present disclosure, the charging-discharging state of the target object is determined; the object data of the target object is partitioned based on the charging-discharging state of the target object to obtain the data set in at least one time interval; the voltage of a random battery cell in a random time interval is obtained based on the voltage of each of the battery cores included in the random battery cell included in the data set in the random time interval; the voltage of the at least one battery cell in the random time interval is clustered based on a clustering algorithm to obtain multiple battery cell voltage clusters in the random time interval; suspected voltage outlier clusters and voltage outlier clusters are determined from the multiple battery cell voltage clusters in the at least one time interval; and whether the target object has the battery cell voltage outliers is determined based on the number of the suspected voltage outlier clusters and the number of the voltage outlier clusters. By determining the charging-discharging state of the target object, and then acquiring the BC voltage data of the high SOC charging stage and a steady-state discharging stage respectively, the data of the charging stage and the discharging stage can be covered, thereby achieving all-weather detection of the battery cores. After the suspected voltage outlier clusters in the battery cell are detected, the voltage outlier clusters are determined, so that the battery cell voltage can be effectively detected and efficient and safe operation of a battery system can be ensured.

An embodiment of the present disclosure further provides a computer storage medium. The computer storage medium stores a program instruction, and the program instruction, when executed, implements the corresponding method as described in the aforementioned embodiments.

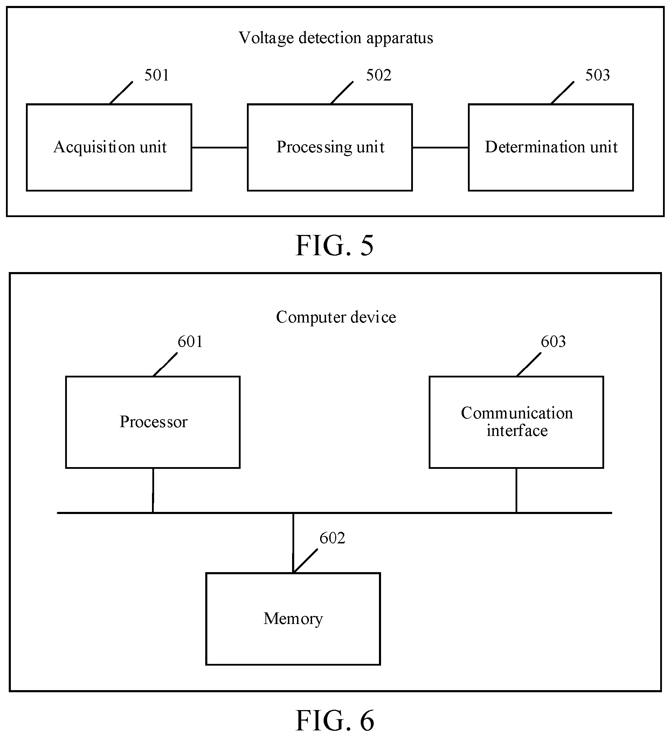

Further refer to FIG. 5, FIG. 5 is a schematic structural diagram of a voltage detection apparatus provided in an embodiment of the present disclosure.

In one implementation of the voltage detection apparatus provided in an embodiment of the present disclosure, the voltage detection apparatus comprises the following structure:
an acquisition unit 501, configured to acquire a data set of a target object in at least one time interval, where the data set comprises voltages of battery cores included in at least one battery cell of the target object;
a processing unit 502, configured to obtain a voltage of a random battery cell in a random time interval based on voltages of battery cores included in the random battery cell included in a data set in the random time interval,
the processing unit 502 is further configured to cluster a voltage of the at least one battery cell in the random time interval based on a clustering algorithm to obtain multiple battery cell voltage clusters in the random time interval; and
a determination unit 503, configured to determine suspected voltage outlier clusters and voltage outlier clusters from multiple battery cell voltage clusters in the at least one time interval,
the determination unit 503 is further configured to determine whether the target object has battery cell voltage outliers based on a number of the suspected voltage outlier clusters and a number of the voltage outlier clusters.

In one embodiment, a method for determining the voltage outlier clusters by the determination unit 503 comprises:
a first voltage mean of voltages within a currently traversed suspected voltage outlier cluster, and second voltage means of suspected voltage outlier clusters, other than the currently traversed suspected voltage outlier cluster, in the suspected voltage outlier clusters in the at least one time interval are acquired; and
the voltage outlier clusters are determined based on the first voltage mean and each of the second voltage means until the traversal ends.

In one embodiment, the step that the determination unit 503 determines the voltage outlier clusters based on the first voltage mean and each of the second voltage means until the traversal ends comprises:
the currently traversed suspected voltage outlier cluster is determined as the voltage outlier cluster if an absolute value of a difference between each of the second voltage means and the first voltage mean is greater than a first preset voltage threshold, until the traversal ends.

In one embodiment, the step that the determination unit 503 determines whether the target object has the battery cell voltage outliers based on the number of the suspected voltage outlier clusters and the number of the voltage outlier clusters comprises:
it is determined that the target vehicle has the battery cell voltage outliers if a ratio of the number of the voltage outlier clusters to the number of the suspected voltage outlier clusters is greater than a first preset ratio threshold, or a difference between the number of the voltage outlier clusters and a number of suspected voltage outlier clusters, other than the voltage outlier clusters, in the suspected voltage outlier clusters is greater than a preset number threshold.

**In** one embodiment, the acquisition unit 501 is further configured to
acquire object data of the target object, where the object data of the target object comprises voltages of battery cores included in at least one battery cell of the target object in a historical time period; and
partition the object data of the target object to obtain a data set of the target object in at least one time interval.

**In** one embodiment, the object data further comprises: a state of charge of each of battery cores included in at least one battery cell in the target object in a historical time period.

The step that the processing unit 502 partitions the object data of the target object to obtain the data set in the at least one time interval of the target object comprises: voltages of the battery cores included in the at least one battery cell at a random time point are acquired from the object data;
a target voltage at the random time point is acquired from at least one voltage at the random time point, where the target voltage is higher than other voltages in the at least one voltage;
a target state of charge of a battery core corresponding to the target voltage at the random time point is acquired;
target object data is determined based on the target voltage and the target state of charge; and
the target object data being continuous in time in the object data is determined as a data set in a time interval to obtain the data set in the at least one time interval. **In** one embodiment, the step that the determination unit 503 determines the target object data based on the target voltage and the target state of charge comprises:
object data at the random time point in the object data is determined as the target object data if the target voltage is greater than a second preset voltage threshold and the target state of charge is greater than a second preset ratio threshold.

In one embodiment, the object data further comprises: a current of a random battery core included in the at least one battery cell in the target object in the historical time period.

The step that the processing unit 502 partitions the object data of the target object to obtain the data set in the at least one time interval of the target object comprises: a current of the random battery core at a random time point, and currents of the random battery core at k time points adjacent to the random time point, are acquired from the object data, and k is a positive integer;
the target object data is determined based on the current at the random time point and the currents at the k adjacent time points; and
the target object data being continuous in time in the object data is determined as a data set in a time interval to obtain the data set in the at least one time interval.

In one embodiment, the step that the determination unit 503 determines the target object data based on the current at the random time point and the currents at the k adjacent time points comprises:
the object data at the random time point in the object data is determined as the target object data if the current at the random time point is less than a first preset current threshold, and a difference between a maximum current and a minimum current of the currents at the k adjacent time points and the current at the random time point is less than a second preset current threshold.

In one embodiment, the step that the processing unit 502 clusters the voltage of the at least one battery cell in the random time interval based on the clustering algorithm to obtain the multiple battery cell voltage clusters in the random time interval comprises:
the voltage of the at least one battery cell in the random time interval is clustered based on the clustering algorithm to obtain multiple candidate battery cell voltage clusters;
the multiple candidate battery cell voltage clusters are clustered based on the clustering algorithm to obtain multiple clustered candidate battery cell voltage clusters if a number of the multiple candidate battery cell voltage clusters is greater than a preset value;
the multiple clustered candidate battery cell voltage clusters are taken as multiple candidate battery cell voltage clusters if a number of the multiple clustered candidate battery cell voltage clusters is greater than the preset value, and performance of clustering the multiple candidate battery cell voltage clusters based on the clustering algorithm is triggered to obtain multiple clustered candidate battery cell voltage clusters, until the number of the multiple clustered candidate battery cell voltage clusters obtained is equal to the preset value; and
the multiple clustered candidate battery cell voltage clusters with the number being equal to the preset value are determined as the multiple battery cell voltage clusters in the random time interval.

In the embodiments of the present disclosure, the acquisition unit 501 acquires a data set of a target object in at least one time interval, where the data set comprises voltages of battery cores included in at least one battery cell of the target object; the processing unit 502 obtains the voltage of the random battery cell in the random time interval based on the voltage of each of the battery cores included in the random battery cell included in the data set in the random time interval; the processing unit 502 clusters the voltage of the at least one battery cell in the random time interval based on the clustering algorithm to obtain the multiple battery cell voltage clusters in the random time interval; the determination unit 503 determines the suspected voltage outlier clusters and the voltage outlier clusters from the multiple battery cell voltage clusters in the at least one time interval; and the determination unit 503 determines whether the target object has the battery cell voltage outliers based on the number of the suspected voltage outlier clusters and the number of the voltage outlier clusters. After the suspected voltage outlier clusters in the battery cell are detected, the voltage outlier clusters are determined, so that the battery cell voltage can be effectively detected and efficient and safe operation of a battery system can be ensured. Further refer to FIG. 6, FIG. 6 is a schematic structural diagram of a computer device provided in an embodiment of the present disclosure. The computer device provided in this embodiment of the present disclosure includes a power supply module and other structures. The computer device can run on a cloud server or a local server, and comprises a processor 601, a memory 602, and a communication interface 603. The processor 601, the memory 602, and the communication interface 603 can exchange data, and a corresponding voltage detection method is implemented by the processor 601.

The memory 602 may include a volatile memory, such as a random-access memory (RAM). The memory 602 may also include a non-volatile memory, such as a flash memory and a solid-state drive (SSD). The memory 602 may also include a combination of the aforementioned types of memories.

The processor 601 may be a central processing unit (CPU). The processor 601 may also be a combination of a CPU and a GPU. In a computer device, multiple CPUs and GPUs may be included as needed for performing corresponding voltage detection. In one embodiment, the memory 602 is configured to store a program instruction. The processor 601 can call the program instruction to implement various methods as described in the embodiments of the present disclosure.

In a first possible implementation, the processor 601 of the computer device calls the program instruction stored in the memory 602, to: acquire a data set of a target object in at least one time interval, where the data set comprises voltages of battery cores included in at least one battery cell of the target object; obtain a voltage of a random battery cell in a random time interval based on voltages of battery cores comprised in the random battery cell comprised in a data set in the random time interval; cluster a voltage of the at least one battery cell in the random time interval based on a clustering algorithm to obtain a multiple battery cell voltage clusters in the random time interval; determine suspected voltage outlier clusters and voltage outlier clusters from multiple battery cell voltage clusters in the at least one time interval; and determine whether the target object has battery cell voltage outliers based on a number of the suspected voltage outlier clusters and a number of the voltage outlier clusters. In one embodiment, the processor 601 can perform the following operations to determine the voltage outlier clusters:
a first voltage mean of voltages within a currently traversed suspected voltage outlier cluster, and second voltage means of suspected voltage outlier clusters, other than the currently traversed suspected voltage outlier cluster, in the suspected voltage outlier clusters in the at least one time interval are acquired; and
the voltage outlier clusters are determined based on the first voltage mean and each of the second voltage means until the traversal ends.

In one embodiment, the processor 601 can perform the following operations to determine the voltage outlier clusters based on the first voltage mean and each of the second voltage means until the traversal ends:
the currently traversed suspected voltage outlier cluster is determined as the voltage outlier cluster if an absolute value of a difference between each of the second voltage means and the first voltage mean is greater than a first preset voltage threshold, until the traversal ends.

In one embodiment, the processor 601 can perform the following operations to determine whether the target object has the battery cell voltage outliers based on the number of the suspected voltage outlier clusters and the number of the voltage outlier clusters:
it is determined that the target object has the battery cell voltage outliers if a ratio of the number of the voltage outlier clusters to the number of the suspected voltage outlier clusters is greater than a first preset ratio threshold, or a difference between the number of the voltage outlier clusters and a number of suspected voltage outlier clusters, other than the voltage outlier clusters, in the suspected voltage outlier clusters is greater than a preset number threshold.

In one embodiment, the processor 601 can also perform the following operations:
acquire object data of the target object, where the object data of the target object comprises voltages of battery cores included in at least one battery cell of the target object in a historical time period; and
partition the object data of the target object to obtain a data set of the target object in at least one time interval.

In one embodiment, the object data further comprises: a state of charge of each of battery cores included in at least one battery cell in the target object in a historical time period.

The processer 601 can perform the following operations to partition the object data of the target object to obtain the data set in the at least one time interval of the target object:
voltages of the battery cores included in the at least one battery cell at a random time point are acquired from the object data;
a target voltage at the random time point is acquired from at least one voltage at the random time point, where the target voltage is higher than other voltages in the at least one voltage;
a target state of charge of a battery core corresponding to the target voltage at the random time point is acquired;
target object data is determined based on the target voltage and the target state of charge; and
the target object data being continuous in time in the object data is determined as a data set in a time interval to obtain the data set in the at least one time interval.

In one embodiment, the processor 601 can perform the following operations to determine the target object data based on the target voltage and the target state of charge:
object data at the random time point in the object data is determined as the target object data if the target voltage is greater than a second preset voltage threshold and the target state of charge is greater than a second preset ratio threshold.

In one embodiment, the object data further comprises: a current of a random battery core included in the at least one battery cell in the target object in the historical time period.

The processer 601 can perform the following operations to partition the object data of the target object to obtain the data set in the at least one time interval of the target object:
a current of the random battery core at a random time point, and currents of the random battery core at k time points adjacent to the random time point, are acquired from the object data, and k is a positive integer;
the target object data is determined based on the current at the random time point and the currents at the k adjacent time points; and
the target object data being continuous in time in the object data is determined as a data set in a time interval to obtain the data set in the at least one time interval.

In one embodiment, the following operation can be performed to determine the target object data based on the current at the random time point and the currents at the k adjacent time points:
the object data at the random time point in the object data is determined as the target object data if the current at the random time point is less than a first preset current threshold, and a difference between a maximum current and a minimum current of the currents at the k adjacent time points and the current at the random time point is less than a second preset current threshold.

In one embodiment, the processor 601 can perform the following operations to cluster the voltage of the at least one battery cell in the random time interval based on the clustering algorithm to obtain the multiple battery cell voltage clusters in the random time interval:
the voltage of the at least one battery cell in the random time interval is clustered based on the clustering algorithm to obtain multiple candidate battery cell voltage clusters;
the multiple candidate battery cell voltage clusters are clustered based on the clustering algorithm to obtain multiple clustered candidate battery cell voltage clusters if a number of the multiple candidate battery cell voltage clusters is greater than a preset value;
the multiple clustered candidate battery cell voltage clusters are taken as multiple candidate battery cell voltage clusters if a number of the multiple clustered candidate battery cell voltage clusters is greater than the preset value, and performance of clustering the multiple candidate battery cell voltage clusters based on the clustering algorithm is triggered to obtain multiple clustered candidate battery cell voltage clusters, until the number of the multiple clustered candidate battery cell voltage clusters obtained is equal to the preset value; and
the multiple clustered candidate battery cell voltage clusters with the number being equal to the preset value are determined as the multiple battery cell voltage clusters in the random time interval.

In the embodiments of the present disclosure, the processor 601 acquires a data set of a target object in at least one time interval, where the data set comprises voltages of battery cores included in at least one battery cell of the target object; obtains a voltage of a random battery cell in a random time interval based on voltages of battery cores included in the random battery cell included in a data set in the random time interval; clusters the voltage of the at least one battery cell in the random time interval based on a clustering algorithm to obtain multiple battery cell voltage clusters in the random time interval; determines suspected voltage outlier clusters and voltage outlier clusters from multiple battery cell voltage clusters in the at least one time interval; and determines whether the target object has battery cell voltage outliers based on a number of the suspected voltage outlier clusters and a number of the voltage outlier clusters. After the suspected voltage outlier clusters in the battery cell are detected, the voltage outlier clusters are determined, so that the battery cell voltage can be effectively detected and efficient and safe operation of a battery system can be ensured.

Those of ordinary skill in the art can understand that all or part of the processes of the methods in the aforementioned embodiments may be implemented, and the processes may be implemented by instructing relevant hardware via a computer program. The program may be stored in a computer-readable storage medium, and when executed, the program may include the processes in the aforementioned method embodiments. The aforementioned storage medium comprises: any medium that can store program code, such as an ROM or a random access memory (RAM), a magnetic disk, or an optical disk.

Disclosed above are merely some of the embodiments of the present disclosure, and certainly, the scope of the rights of the present disclosure cannot be limited thereto, the scope of the invention being defined by the appended claims. Those of ordinary skill in the art can understand and implement all or part of the processes of the above embodiments, and equivalent changes made according to the claims of the present disclosure still fall within the scope of the disclosure.

## Claims

1. A voltage detection method for execution by a processor, comprising:
acquiring (201) a data set of a target object in at least one time interval, the data set comprising voltages of battery cores comprised in at least one battery cell of the target object;
obtaining (202) voltages of a random battery cell in a random time interval based on voltages of battery cores comprised in the random battery cell comprised in a data set in the random time interval;
clustering (203) voltages of the at least one battery cell in the random time interval based on a clustering algorithm to obtain a plurality of battery cell voltage clusters in the random time interval;
determining (204) suspected voltage outlier clusters and voltage outlier clusters from a plurality of battery cell voltage clusters in the at least one time interval; and
determining (205) whether the target object has battery cell voltage outliers based on a number of the suspected voltage outlier clusters and a number of the voltage outlier clusters.

2. The method of claim 1, wherein determining the voltage outlier clusters comprises:
acquiring a first voltage mean of voltages comprised in a currently traversed suspected voltage outlier cluster, and second voltage means of suspected voltage outlier clusters, other than the currently traversed suspected voltage outlier cluster, in the suspected voltage outlier clusters in the at least one time interval; and
determining the voltage outlier clusters based on the first voltage mean and each of the second voltage means until the traversal ends.

3. The method of claim 2, wherein determining the voltage outlier clusters based on the first voltage mean and each of the second voltage means until the traversal ends comprises:
determining the currently traversed suspected voltage outlier cluster as the voltage outlier cluster if an absolute value of a difference between each of the second voltage means and the first voltage mean is greater than a first preset voltage threshold, until the traversal ends.

4. The method of claim 1, wherein determining whether the target object has battery cell voltage outliers based on a number of the suspected voltage outlier clusters and a number of the voltage outlier clusters comprises:
determining that the target object has the battery cell voltage outliers if a ratio of the number of the voltage outlier clusters to the number of the suspected voltage outlier clusters is greater than a first preset ratio threshold, or a difference between the number of the voltage outlier clusters and a number of suspected voltage outlier clusters, other than the voltage outlier clusters, in the suspected voltage outlier clusters is greater than a preset number threshold.

5. The method of claim 1, further comprising:
acquiring object data of the target object, the object data of the target object comprising voltages of battery cores comprised in at least one battery cell of the target object in a historical time period; and
partitioning the object data of the target object to obtain the data set in the at least one time interval of the target object.

6. The method of claim 5, wherein the object data further comprises: a state of charge of each of the battery cores comprised in the at least one battery cell in the target object in the historical time period; and time interval of the target object comprises: acquiring voltages of the battery cores comprised in the at least one battery cell at a random time point from the object data;
acquiring a target voltage at the random time point from at least one voltage at the random time point, the target voltage being higher than other voltages in the at least one voltage;
acquiring a target state of charge of a battery core corresponding to the target voltage at the random time point;
determining target object data based on the target voltage and the target state of charge; and
determining the target object data being continuous in time in the object data as a data set in a time interval to obtain the data set in the at least one time interval.

7. The method of claim 6, wherein determining target object data based on the target voltage and the target state of charge comprises:
determining object data at the random time point in the object data as the target object data if the target voltage is greater than a second preset voltage threshold and the target state of charge is greater than a second preset ratio threshold.

8. The method of claim 5, wherein the object data further comprises: a current of a random battery core comprised in the at least one battery cell in the target object in the historical time period; and
partitioning the object data of the target object to obtain the data set in the at least one time interval of the target object comprises: acquiring a current of the random battery core at a random time point, and currents of the random battery core at k time points adjacent to the random time point, from the object data, k being a positive integer;
determining target object data based on the current at the random time point and the currents at the k adjacent time points; and
determining the target object data being continuous in time in the object data as a data set in a time interval to obtain the data set in the at least one time interval.

9. The method of claim 8, wherein determining the target object data based on the current at the random time point and the currents at the k adjacent time points comprises:
determining the object data at the random time point in the object data as the target object data if the current at the random time point is less than a first preset current threshold, and a difference between a maximum current and a minimum current of the currents at the k adjacent time points and the current at the random time point is less than a second preset current threshold.

10. The method of claim 1, wherein clustering the voltage of the at least one battery cell in the random time interval based on the clustering algorithm to obtain the plurality of battery cell voltage clusters in the random time interval comprises:
clustering the voltage of the at least one battery cell in the random time interval based on the clustering algorithm to obtain a plurality of candidate battery cell voltage clusters;
clustering the plurality of candidate battery cell voltage clusters based on the clustering algorithm to obtain a plurality of clustered candidate battery cell voltage clusters if a number of the plurality of candidate battery cell voltage clusters is greater than a preset value;
taking the plurality of clustered candidate battery cell voltage clusters as a plurality of candidate battery cell voltage clusters if a number of the plurality of clustered candidate battery cell voltage clusters is greater than the preset value, and triggering performance of the clustering the plurality of candidate battery cell voltage clusters based on the clustering algorithm to obtain a plurality of clustered candidate battery cell voltage clusters, until the number of the plurality of clustered candidate battery cell voltage clusters obtained is equal to the preset value; and
determining the plurality of clustered candidate battery cell voltage clusters with the number being equal to the preset value as the plurality of battery cell voltage clusters in the random time interval.

11. A computer device, comprising a memory (602), a communication interface (603), and a processor(601), wherein the memory (602), the communication interface (603), and the processor (601) are interconnected; and the memory (602) stores a computer program comprising instructions which, when executed by the processor (601) cause the processor to carry out the method of any one of claims 1 to 10.

12. A vehicle, comprising a vehicle body and a processor (601), and the processor (601) being configured to execute the method of any one of claims 1 to 10.

13. A computer-readable storage medium, storing a computer program, and the computer program, when executed by a processor (601), causing the processor to carry out the method of any one of claims 1 to 10.

## Patentansprüche

1. Spannungserkennungsverfahren zum Ausführen durch einen Prozessor, Folgendes umfassend:
Erfassen (201) eines Datensatzes eines Zielobjekts in mindestens einem Zeitintervall, wobei der Datensatz Spannungen von Batteriekernen umfasst, die in mindestens einer Batteriezelle des Zielobjekts enthalten sind;
Erhalten (202) von Spannungen einer zufälligen Batteriezelle in einem zufälligen Zeitintervall, basierend auf Spannungen von Batteriekernen, die in der zufälligen Batteriezelle enthalten sind, welche in einem Datensatz in dem zufälligen Zeitintervall enthalten ist;
Clustern (203) von Spannungen der mindestens einen Batteriezelle in dem zufälligen Zeitintervall basierend auf einem Clustering-Algorithmus, um eine Vielzahl von Batteriezellespannungs-Clustern in dem zufälligen Zeitintervall zu erhalten;
Bestimmen (204) von vermuteten Spannungsausreißer-Clustern und Spannungsausreißer-Clustern aus mehreren Batteriezellespannungs-Clustern in dem mindestens einen Zeitintervall; und
Bestimmen (205), ob das Zielobjekt Batteriezellenspannungsausreißer aufweist, basierend auf einer Anzahl der vermuteten Spannungsausreißer-Cluster und einer Anzahl der Spannungsausreißer-Cluster.

2. Verfahren nach Anspruch 1, wobei das Bestimmen der Spannungsausreißer-Cluster Folgendes umfasst:
Erfassen eines ersten Spannungsmittels von Spannungen, die in einem gegenwärtig traversierten vermuteten Spannungsausreißer-Cluster enthalten sind, und eines zweiten Spannungsmittels vermuteter Spannungsausreißer-Cluster, die nicht die gegenwärtig traversierten vermuteten Spannungsausreißer-Cluster sind, in den vermuteten Spannungsausreißer-Clustern in dem mindestens einen Zeitintervall; und
Bestimmen der Spannungsausreißer-Cluster basierend auf dem ersten Spannungsmittel und jedem der zweiten Spannungsmittel, bis die Traverse endet.

3. Verfahren nach Anspruch 2, wobei das Bestimmen der Spannungsausreißer-Cluster basierend auf dem ersten Spannungsmittel und jedem der zweiten Spannungsmittel, bis die Traverse endet, Folgendes umfasst:
Bestimmen des gegenwärtig traversierten vermuteten Spannungsausreißer-Clusters als den Spannungsausreißer-Cluster, wenn ein absoluter Wert einer Differenz zwischen jedem der zweiten Spannungsmittel und dem ersten Spannungsmittel größer als ein erster vorab festgelegter Spannungsschwellenwert ist, bis die Traverse endet.

4. Verfahren nach Anspruch 1, wobei das Bestimmen, ob das Zielobjekt Batteriezellenspannungsausreißer aufweist, basierend auf einer Anzahl der vermuteten Spannungsausreißer-Cluster und einer Anzahl der Spannungsausreißer-Cluster, Folgendes umfasst:
Bestimmen, dass das Zielobjekt die Batteriezellenspannungsausreißer aufweist, wenn ein Verhältnis der Anzahl der Spannungsausreißer-Cluster zur Anzahl der vermuteten Spannungsausreißer-Cluster größer als ein erster vorab festgelegter Verhältnisschwellenwert ist oder eine Differenz zwischen den Anzahl der Spannungsausreißer-Cluster und einer Anzahl vermuteter Spannungsausreißer-Cluster, die nicht die Spannungsausreißer-Cluster sind, in den vermuteten Spannungsausreißer-Clustern größer als ein vorab festgelegter Anzahlschwellenwert ist.

5. Verfahren nach Anspruch 1, ferner Folgendes umfassend:
Erfassen von Objektdaten des Zielobjekts, wobei die Objektdaten des Zielobjekts Spannungen von Batteriekernen umfassen, die in mindestens einer Batteriezelle des Zielobjekts in einer historischen Zeitspanne enthalten sind; und
Partitionieren der Objektdaten des Zielobjekts, um den Datensatz in dem mindestens einem Zeitintervall des Zielobjekts zu erhalten.

6. Verfahren nach Anspruch 5, wobei die Objektdaten ferner Folgendes umfassen: einen Ladezustand jedes der Batteriekerne, die in der mindestens einen Batteriezelle in dem Zielobjekt in der historischen Zeitspanne enthalten sind; und
wobei das Zeitintervall des Zielobjekts Folgendes umfasst: Erfassen von Spannungen der Batteriekerne, die in der mindestens einen Batteriezelle enthalten sind, zu einem zufälligen Zeitpunkt aus den Objektdaten;
Erfassen einer Zielspannung zu dem zufälligen Zeitpunkt aus mindestens einer Spannung zu dem zufälligen Zeitpunkt, wobei die Zielspannung höher als andere Spannungen in der mindesten einen Spannung ist;
Erfassen eines Zielladezustands eines Batteriekerns, welcher der Zielspannung zu dem zufälligen Zeitpunkt entspricht;
Bestimmen von Zielobjektdaten basierend auf der Zielspannung und dem Zielladezustand; und
Bestimmen der Zielobjektdaten, die in den Objektdaten zeitlich kontinuierlich sind, als einen Datensatz in einem Zeitintervall, um den Datensatz in dem mindesten einen Zeitintervall zu erhalten.

7. Verfahren nach Anspruch 6, wobei das Bestimmen von Zielobjektdaten basierend auf der Zielspannung und dem Zielladezustand Folgendes umfasst:
Bestimmen von Objektdaten zu dem zufälligen Zeitpunkt in den Objektdaten als die Zielobjektdaten, wenn die Zielspannung größer als ein zweiter voreingestellter Spannungsschwellenwert ist und der Zielladezustand größer als ein zweiter voreingestellter Verhältnisschwellenwert ist.

8. Verfahren nach Anspruch 5, wobei die Objektdaten ferner Folgendes umfassen: eine Stromstärke eines zufälligen Batteriekerns, der in der mindestens einen Batteriezelle in dem Zielobjekt in der historischen Zeitspanne enthalten ist; und
das Partitionieren der Objektdaten des Zielobjekts, um den Datensatz in dem mindestens einen Zeitintervall des Zielobjekts zu erhalten, Folgendes umfasst: Erfassen einer Stromstärke des zufälligen Batteriekerns zu einem zufälligen Zeitpunkt und der Stromstärken des zufälligen Batteriekerns zu k Zeitpunkten, die benachbart zu dem zufälligen Zeitpunkt liegen, aus den Objektdaten, wobei k eine positive ganze Zahl ist;
Bestimmen von Zielobjektdaten basierend auf der Stromstärke zu dem zufälligen Zeitpunkt und den Stromstärken zu den k benachbarten Zeitpunkten; und
Bestimmen der Zielobjektdaten, die in den Objektdaten zeitlich kontinuierlich sind, als einen Datensatz in einem Zeitintervall, um den Datensatz in dem mindesten einen Zeitintervall zu erhalten.

9. Verfahren nach Anspruch 8, wobei das Bestimmen von Zielobjektdaten basierend auf der Stromstärke zu dem zufälligen Zeitpunkt und den Stromstärken zu den k benachbarten Zeitpunkten, Folgendes umfasst:
Bestimmen der Objektdaten zu dem zufälligen Zeitpunkt in den Objektdaten als die Zielobjektdaten, wenn die Stromstärke zu dem zufälligen Zeitpunkt kleiner als ein erster vorab festgelegter Stromstärkenschwellenwert ist und eine Differenz zwischen einer maximalen Stromstärke und einer minimalen Stromstärke der Stromstärken zu den k benachbarten Zeitpunkten und der Stromstärke zu dem zufälligen Zeitpunkt kleiner als ein zweiter vorab festgelegter Stromstärkenschwellenwert ist.

10. Verfahren nach Anspruch 1, wobei das Clustern der Spannung der mindestens einen Batteriezelle in dem zufälligen Zeitintervall basierend auf dem Clustering-Algorithmus, um die Vielzahl von Batteriezellespannungs-Clustern in dem zufälligen Zeitintervall zu erhalten, Folgendes umfasst:
Clustern der Spannungen der mindestens einen Batteriezelle in dem zufälligen Zeitintervall basierend auf dem Clustering-Algorithmus, um eine Vielzahl von Kandidaten-Batteriezellespannungs-Clustern zu erhalten;
Clustern der Vielzahl von Kandidaten-Batteriezellespannungs-Clustern basierend auf dem Clustering-Algorithmus, um eine Vielzahl von geclusterten Kandidaten-Batteriezellespannungs-Clustern zu erhalten, wenn eine Anzahl der Vielzahl von Kandidaten-Batteriezellespannungs-Clustern größer als ein vorab festgelegter Wert ist;
Übernehmen der Vielzahl von geclusterten Kandidaten-Batteriezellespannungs-Clustern als eine Vielzahl von Kandidaten-Batteriezellespannungs-Clustern, wenn eine Anzahl der Vielzahl von geclusterten Kandidaten-Batteriezellespannungs-Clustern größer als der vorab festgelegte Wert sind, und Auslösen der Durchführung des Clusterns der Vielzahl von Kandidaten-Batteriezellespannungs-Clustern basierend auf dem Clustering-Algorithmus, um eine Vielzahl von geclusterten Kandidaten-Batteriezellespannungs-Clustern zu erhalten, bis die Anzahl der erhaltenen Vielzahl von Kandidaten-Batteriezellespannungs-Clustern gleich dem vorab festgelegten Wert ist; und
Bestimmen der Vielzahl von geclusterten Kandidaten-Batteriezellespannungs-Clustern, deren Anzahl gleich dem vorab festgelegten Wert ist, als die Vielzahl von Batteriezellespannungs-Clustern in dem zufälligen Zeitintervall.

11. Computervorrichtung, einen Speicher (602), eine Kommunikationsschnittstelle (603) und einen Prozessor (601) umfassend, wobei der Speicher (602), die Kommunikationsschnittstelle (603) und der Prozessor (601) miteinander verbunden sind; und der Speicher (602) ein Computerprogramm speichert, das Anweisungen umfasst, die bei Ausführung durch den Prozessor (601) den Prozessor veranlassen, das Verfahren nach einem der Ansprüche 1 bis 10 auszuführen.

12. Fahrzeug, eine Fahrzeugkarosserie und einen Prozessor (601) umfassend, wobei der Prozessor (601) dazu konfiguriert ist, das Verfahren nach einem der Ansprüche 1 bis 10 auszuführen.

13. Computerlesbares Speichermedium, das ein Computerprogramm speichert, wobei das Computerprogramm bei Ausführung durch einen Prozessor (601) den Prozessor veranlasst, das Verfahren nach einem der Ansprüche 1 bis 10 auszuführen.

## Revendications

1. Procédé de détection de tension destiné à être exécuté par un processeur, comprenant :
l'acquisition (201) d'un ensemble de données d'un objet cible dans au moins un intervalle de temps, ledit ensemble de données comprenant des tensions de cœurs de batterie compris dans au moins un élément de batterie de l'objet cible ;
l'obtention (202) de tensions d'un élément de batterie aléatoire dans un intervalle de temps aléatoire sur la base de tensions de cœurs de batterie compris dans l'élément de batterie aléatoire comprises dans un ensemble de données dans l'intervalle de temps aléatoire ;
le regroupement (203) de tensions de l'au moins un élément de batterie dans l'intervalle de temps aléatoire sur la base d'un algorithme de regroupement pour obtenir une pluralité de groupes de tension d'élément de batterie dans l'intervalle de temps aléatoire ;
la détermination (204) de groupes de valeurs aberrantes de tension suspectées et de groupes de valeurs aberrantes de tension à partir d'une pluralité de groupes de tension d'élément de batterie dans ledit au moins un intervalle de temps ; et
le fait de déterminer (205) si l'objet cible présente des valeurs aberrantes de tension d'élément de batterie sur la base d'un nombre des groupes de valeurs aberrantes de tension suspectées et d'un nombre des groupes de valeurs aberrantes de tension.

2. Procédé selon la revendication 1, dans lequel la détermination des groupes de valeurs aberrantes de tension comprend :
l'acquisition d'une première moyenne de tension de tensions comprises dans un groupe de valeurs aberrantes de tension suspectées actuellement traversé, et de secondes moyennes de tension de groupes de valeurs aberrantes de tension suspectées, autres que le groupe de valeurs aberrantes de tension suspectées actuellement traversé, dans les groupes de valeurs aberrantes de tension suspectées dans l'au moins un intervalle de temps ; et
la détermination des groupes de valeurs aberrantes de tension sur la base de la première moyenne de tension et de chacune des secondes moyennes de tension jusqu'à ce que la traversée se termine.

3. Procédé selon la revendication 2, dans lequel la détermination des groupes de valeurs aberrantes de tension sur la base de la première moyenne de tension et de chacune des secondes moyennes de tension jusqu'à la ce que la traversée se termine comprend :
la détermination du groupe de valeurs aberrantes de tension suspectées actuellement traversé en tant que groupe de valeurs aberrantes de tension si une valeur absolue d'une différence entre chacune des secondes moyennes de tension et la première moyenne de tension est supérieure à un premier seuil de tension prédéfini, jusqu'à ce que la traversée se termine.

4. Procédé selon la revendication 1, dans lequel le fait de déterminer si l'objet cible présente des valeurs aberrantes de tension d'élément de batterie sur la base d'un nombre des groupes de valeurs aberrantes de tension suspectées et d'un nombre des groupes de valeurs aberrantes de tension comprend :
le fait de déterminer que l'objet cible présente les valeurs aberrantes de tension d'élément de batterie si un rapport entre le nombre des groupes de valeurs aberrantes de tension et le nombre des groupes de valeurs aberrantes de tension suspectées est supérieur à un premier seuil de rapport prédéfini, ou si une différence entre le nombre des groupes de valeurs aberrantes de tension et un nombre des groupes de valeurs aberrantes de tension suspectées, autres que les groupes de valeurs aberrantes de tension, dans les groupes de valeurs aberrantes de tension suspectées est supérieure à un seuil numérique prédéfini.

5. Procédé selon la revendication 1, comprenant en outre :
l'acquisition de données d'objet de l'objet cible, les données d'objet de l'objet cible comprenant des tensions de cœurs de batterie compris dans au moins un élément de batterie de l'objet cible dans une période de temps historique ; et
le partitionnement des données d'objet de l'objet cible pour obtenir l'ensemble de données dans l'au moins un intervalle de temps de l'objet cible.

6. Procédé selon la revendication 5, dans lequel les données d'objet comprennent en outre : un état de charge de chacun des cœurs de batterie compris dans l'au moins un élément de batterie dans l'objet cible dans la période de temps historique ; et
intervalle de temps de l'objet cible comprend : l'acquisition de tensions des cœurs de batterie compris dans l'au moins un élément de batterie à un instant aléatoire à partir des données d'objet ;
l'acquisition d'une tension cible à l'instant aléatoire à partir d'au moins une tension à l'instant aléatoire, la tension cible étant supérieure à d'autres tensions dans l'au moins une tension ;
l'acquisition d'un état de charge cible d'un cœur de batterie correspondant à la tension cible à l'instant aléatoire ;
la détermination de données d'objet cible sur la base de la tension cible et de l'état de charge cible ; et
le fait de déterminer que les données d'objet cible sont continues dans le temps dans les données d'objet en tant qu'ensemble de données dans un intervalle de temps pour obtenir l'ensemble de données dans l'au moins un intervalle de temps.

7. Procédé selon la revendication 6, dans lequel la détermination de données d'objet cible sur la base de la tension cible et de l'état de charge cible comprend :
la détermination de données d'objet à l'instant aléatoire dans les données d'objet en tant que données d'objet cible si la tension cible est supérieure à un second seuil de tension prédéfini et que l'état de charge cible est supérieur à un second seuil de rapport prédéfini.

8. Procédé selon la revendication 5, dans lequel les données d'objet comprennent en outre : un courant d'un cœur de batterie aléatoire compris dans l'au moins un élément de batterie dans l'objet cible dans la période de temps historique ; et
le partitionnement des données d'objet de l'objet cible pour obtenir l'ensemble de données dans l'au moins un intervalle de temps de l'objet cible comprend :
l'acquisition d'un courant du cœur de batterie aléatoire à un instant aléatoire, et de courants du cœur de batterie aléatoire à k instants adjacents à l'instant aléatoire, à partir des données d'objet, k étant un nombre entier positif ;
la détermination de données d'objet cible sur la base du courant à l'instant aléatoire et des courants aux k instants adjacents ; et
le fait de déterminer que les données d'objet cible sont continues dans le temps dans les données d'objet en tant qu'ensemble de données dans un intervalle de temps pour obtenir l'ensemble de données dans l'au moins un intervalle de temps.

9. Procédé selon la revendication 8, dans lequel la détermination des données d'objet cible sur la base du courant à l'instant aléatoire et des courants aux k instants adjacents comprend :
la détermination des données d'objet à l'instant aléatoire dans les données d'objet en tant que données d'objet cible si le courant à l'instant aléatoire est inférieur à un premier seuil de courant prédéfini, et qu'une différence entre un courant maximum et un courant minimum des courants aux k instants adjacents et le courant à l'instant aléatoire est inférieure à un second seuil de courant prédéfini.

10. Procédé selon la revendication 1, dans lequel le regroupement de la tension de l'au moins un élément de batterie dans l'intervalle de temps aléatoire sur la base de l'algorithme de regroupement pour obtenir la pluralité de groupes de tension d'élément de batterie dans l'intervalle de temps aléatoire comprend :
le regroupement de la tension de l'au moins un élément de batterie dans l'intervalle de temps aléatoire sur la base de l'algorithme de regroupement pour obtenir une pluralité de groupes de tension d'élément de batterie candidats ;
le regroupement de la pluralité de groupes de tension d'élément de batterie candidats sur la base de l'algorithme de regroupement pour obtenir une pluralité de groupes de tension d'élément de batterie candidats regroupés si un nombre de la pluralité de groupes de tension d'élément de batterie candidats est supérieur à une valeur prédéfinie ;
le fait de prendre la pluralité de groupes de tension d'élément de batterie candidats regroupés en tant que pluralité de groupes de tension d'élément de batterie candidats si un nombre de la pluralité de groupes de tension d'élément de batterie candidats regroupés est supérieur à la valeur prédéfinie, et le déclenchement de l'exécution du regroupement de la pluralité de groupes de tension d'élément de batterie candidats sur la base de l'algorithme de regroupement pour obtenir une pluralité de groupes de tension d'élément de batterie candidats regroupés, jusqu'à ce que le nombre de la pluralité de groupes de tension d'élément de batterie candidats regroupés obtenu soit égal à la valeur prédéfinie ; et
la détermination de la pluralité de groupes de tension d'élément de batterie candidats regroupés, le nombre étant égal à la valeur prédéfinie en tant que pluralité de groupes de tension d'élément de batterie dans l'intervalle de temps aléatoire.

11. Dispositif informatique comprenant une mémoire (602), une interface de communication (603), et un processeur (601), dans lequel la mémoire (602), l'interface de communication (603), et le processeur (601) sont interconnectés ; et la mémoire (602) stocke un programme informatique comprenant des instructions qui, lorsqu'elles sont exécutées par le processeur (601), amènent le processeur à mettre en œuvre le procédé selon l'une quelconque des revendications 1 à 10.

12. Véhicule, comprenant une carrosserie de véhicule et un processeur (601), et le processeur (601) étant configuré pour exécuter le procédé selon l'une quelconque des revendications 1 à 10.

13. Support de stockage lisible par ordinateur, stockant un programme informatique, et le programme informatique, lorsqu'il est exécuté par un processeur (601), amenant le processeur à mettre en œuvre le procédé selon l'une quelconque des revendications 1 à 10.
